Europäisches Patentamt

(19) European Patent Office

Office européen des brevets

(11) Publication number: 0 239 635 B1

(12) EUROPEAN PATENT SPECIFICATION

(45) Date of publication of patent specification :
08.01.92 Bulletin 92/02

(21) Application number: 86906563.1

(22) Date of filing : 03.10.86

(86) International application number :
PCT/US86/02107

(87) International publication number :
WO 87/02478 23.04.87 Gazette 87/09

(51) Int. Cl.⁵: $G02F\ 1/17$, $G02F\ 1/015$,
$G02F\ 1/35$, $G02F\ 3/00$,
$H01L\ 31/02$

(54) NONLINEAR AND BISTABLE OPTICAL DEVICE.

(30) Priority : 08.10.85 US 785546

(43) Date of publication of application :
07.10.87 Bulletin 87/41

(45) Publication of the grant of the patent :
08.01.92 Bulletin 92/02

(84) Designated Contracting States :
DE FR GB IT NL SE

(56) References cited :
EP-A- 0 155 802
WO-A-84/03397

(56) References cited :
Optical Engineering, vol. 24, no. 4, July/August
1985 (Bellingham Washington, US) D.S. Chel-
ma et al.: "Non linear optical properties of
GaAs/GaA1As multiple quantum well material
phenomena and applications"-see page 556,
abstract and paragraph 3, page 557-formula
(2), page 558; figures 13 and 15
See also references of WO8702478

(73) Proprietor : AMERICAN TELEPHONE AND
TELEGRAPH COMPANY
550 Madison Avenue
New York, NY 10022 (US)

(72) Inventor : MILLER, David, Andrew, Barclay
64 Hance Road
Fairhaven, NJ 07701 (US)

(74) Representative : Watts, Christopher Malcolm
Kelway et al
AT&T (UK) LTD. AT&T Intellectual Property
Division 5 Mornington Road
Woodford Green Essex IG8 OTU (GB)

## Description

## Technical Field

This invention relates to nonlinear optical devices, particularly to those devices employing high gain or feedback resulting in multistable optical states or other nonlinear optical response.

## Background of the Invention

Nonlinear and bistable optical devices for use in computing and switching systems must have a low switching energy. A low switching energy allows many similar devices to be packed into a small volume for parallel processing, and also allows high speed switching to be implemented.

Nonlinear and bistable optical devices have in the past required a high switching energy. They have therefore relied upon the high gain of a high finesse optical cavity such as a Fabry Perot Cavity in order to reduce the switching energy needed for either nonlinear or bistable operation. A bistable optical device having a low switching energy is described in U.S. Patent 4,597,638. The optical switching energy between bistable states of this device was somewhat greater than 100 femtojoules/square μm. However a high finesse Fabry Perot cavity was required in order to achieve this low value of the switching energy.

An optical device as set out in the preamble of claim 1 was disclosed in EP-A-0 155 802.

## Summary of the Invention

According to the invention there is provided a device as set out in claim 1.

## Brief Description of the Drawings

FIGS. 1 and 2 are, respectively, a cross-sectional view and a corresponding electrical circuit diagram of a device embodying the invention,

FIGS. 3 and 4 are, respectively, a cross-sectional view and a top view of a device which includes an array of devices embodying the invention and

FIGS. 5 and 6 are, respectively, a cross-sectional view and a corresponding electrical circuit diagram of an optical logic device which embodies the invention.

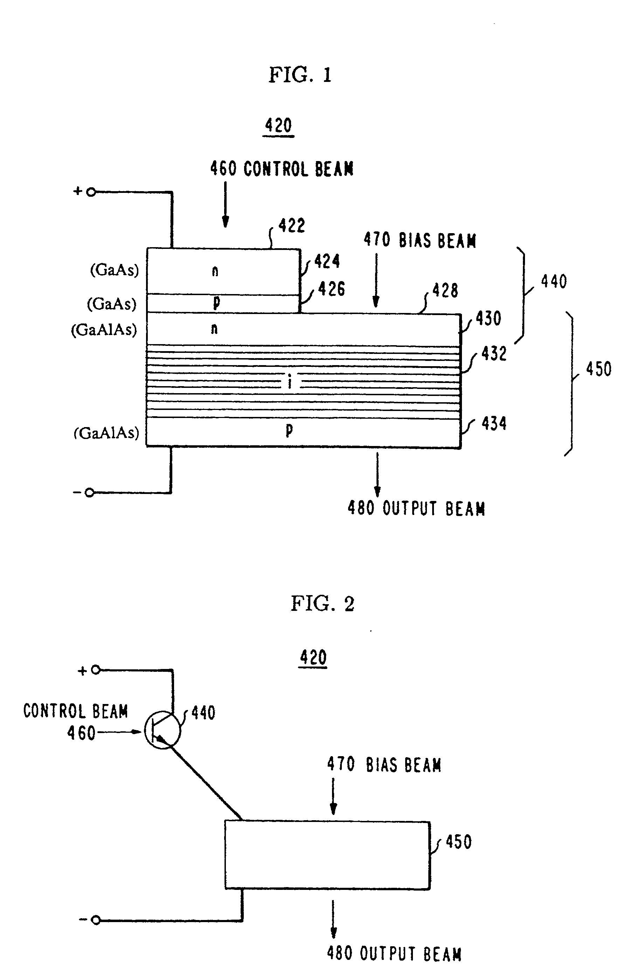

The structure of a device embodying the invention is depicted in FIG. 1, while the corresponding electrical circuit is depicted in FIG. 2.

As shown in FIG. 1, the device 420 includes a phototransistor 440 integral, and in series, with an MQW modulator 450. The phototransistor 440 is, for example, an n-p-n bipolar transistor or a p-n-p bipolar transistor. For purposes of illustration only, the phototransistor depicted in FIG. 1 is an n-p-n transistor which includes an n-type material region 424 having an exposed upper surface 422, a p-type material region 426, and an n-type material region 430. These regions constitute, respectively, the collector, the base, and the emitter of the phototransistor 440 (which, in operation, is biased, as shown in FIG. 1 ).

The MQW modulator 450 is preferably in the form of a p-i-n diode which includes the n-type material region 430, a multi-quantum well region 432 (of intrinsic semiconductor material), and a p-type material region 434. Thus, one of the components of the phototransistor 440, i.e., the n-type region 430 (the emitter), is integral with the modulator 450. (If the phototransistor 440 is a p-n-p transistor, then the positions of the p-type and n-type regions in the modulator 450 are interchanged, and thus a p-type region of the phototransistor is integral with the modulator.)

Significantly, the phototransistor 440 is fabricated (as described more fully below) so that the base 426 and collector 424 overlie only a portion (less than all) of an upper surface 428 of the emitter 430 (the component integral with the modulator 450). This is highly advantageous because, in operation, a control beam 460 is readily impinged upon the exposed, upper surface 422 of the collector 424 (to penetrate into, and be absorbed by, the phototransistor 440). In addition, a bias beam 470 is readily impinged upon the exposed portion of the surface 428 (to penetrate into, and be at least partially absorbed by, the MQW region 432). Because the bias beam 470 need not penetrate the phototransistor,

the wavelength of the bias beam need not be different from that of the control beam. As a consequence, device cascading is readily achievable. Moreover, and by virtue of the use of control and bias beams,         small fluctuations in the bias beam are not amplified by the phototransistor.

As shown in FIG. 1, the device 420 contains a p-n-p parasitic transistor which includes the p-type region 426, the n-type region 430, and the p-type region 434 (the presence of the intrinsic, MQW region 432 does not preclude parasitic transistor action). These regions constitute, respectively, the emitter, the base, and the collector of the parasitic transistor. To avoid undesirable operation in demanding applications, the current gain of the phototransistor 440 should be greater than that of the parasitic transistor. (As used here, the term current gain denotes what is commonly termed β, the dc short-circuit current gain in the common-emitter configuration.) As is known, there are a variety of techniques for enhancing or reducing the current gain of one transistor relative to another. In the device of FIG. 1, it has been found useful to reduce the current gain of the parasitic transistor below that of the phototransistor 440 by, for example, reducing the emitter injection efficiency of the parasitic transistor below that of the phototransistor 440. This is readily achieved by forming the parasitic transistor with a base material region (the region 430) having a higher bandgap than that of the base region (region 426) of the phototransistor 440. (The term bandgap denotes the energy gap between the valence and conduction bands. The larger the bandgap, the larger is the potential barrier seen by majority carriers injected into the base by the emitter, and thus the lower the emitter injection efficiency.) That is, this is achieved by introducing a heterojunction at the interface between the regions 430 and 426. (Regarding heterojunctions see, e.g., H. Kroemer, Proc. IEEE, 70, No. 1, January 1982, pp. 13-25.) Assuming all other factors (affecting current gain) are equal, the bandgap of the base of the parasitic transistor should be greater than that of the base of the phototransistor by at least kT, where k is Boltzmann's constant and T is the desired operating temperature of the device (in degrees Kelvin). Bandgap differences smaller than kT are undesirable because they result in undesirably small reductions in the emitter injection efficiency of the parasitic transistor.

The desired bandgap difference is readily achieved by fabricating the base of the parasitic transistor (the region 430) from, for example, gallium aluminum arsenide (having a bandgap typically of about 1.8 eV). Further, the base of the phototransistor 440 (the region 426) is fabricated from, for example, gallium arsenide (having a bandgap of about 1.4 eV). For the sake of convenience, the remainder of the embodiment 420 is also fabricated from these same materials. That is, and as shown in FIG. 1, the region 424 includes gallium arsenide, the region 434 includes gallium aluminum arsenide, while the MQW region 432 includes interleaved regions of gallium arsenide and gallium aluminum arsenide.

The regions of gallium arsenide and gallium aluminum arsenide, described above, are readily grown on top of one another using, for example, conventional molecular beam epitaxy techniques. Further, a portion of the surface 428 is left exposed by, for example, selective deposition of the regions 424 and 426. Alternatively, the regions 424 and 426 are initially formed so that they entirely cover the surface 428, and then a portion of each of the regions 424 and 426 is etched away, using conventional etchants, to expose a portion of the surface 428.

Significantly, the use of different bandgap materials, as described above, also results in advantageous transmission and absorption properties. For example, if the regions 424 and 426 are of gallium arsenide, and the control beam 460 incident on the surface 422 includes light having a wavelength of, for example, 850 nanometers, then such light will be absorbed by the phototransistor 440. If the bias beam 470 incident on the exposed portion of the surface 428 also includes the same wavelength light (as is desirable for cascading purposes), and if the regions 430 and 434 are of gallium aluminum arsenide, then undesirable absorption of this light by these regions is avoided (by virtue of the higher bandgap of gallium aluminum arsenide). (Absorption of the bias beam by the regions 430 and 434 produces an undesirable attenuation of the output beam.) However, if the MQW region 432 includes interleaved regions of gallium arsenide and gallium aluminum arsenide, then the light will be absorbed by the MQW region, with the absorption being (indirectly) controlled by the control beam.

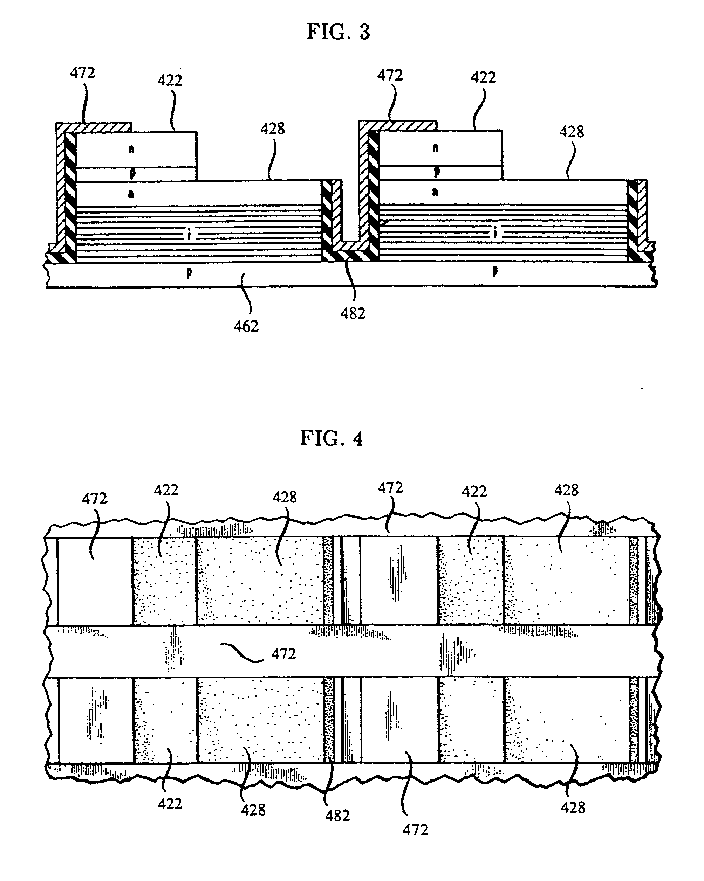

Because the embodiment 420 requires only two electrical contacts (to the top of (emitter) region 424 and the bottom of region 434, as shown in FIG. 1 ), this embodiment lends itself to the formation of structures which include arrays of the embodiment having a common top contact and a common bottom contact. As shown in FIGS. 3-4, such an array includes a plurality of the embodiments 420, formed in a common substrate, with a common bottom electrical contact 462 to the common region 434. If the region 434 is, for example, of gallium aluminum arsenide, then the bottom contact includes, for example, the region 434 itself. A common top contact 472 to the regions 424 (the emitters) of the array is formed by first forming, e.g., depositing, an insulating layer 488 covering all the upper surfaces of the array except the surfaces 422 and 428 (which are to be impinged by the control and bias beams). This insulating layer shields array components from the voltages applied to the emitter regions of the array via the common top contact. If the array is fabricated from gallium arsenide and gallium aluminum arsenide, then useful insulating materials include polyimide, silicon oxide, and silicon nitride. Then the common top contact 472 is formed by depositing the contact layer (or layers) onto all the upper surfaces of the array, including a portion of each surface 422 of each emitter. However, at least a portion of each surface 422 is left exposed for impingement by a control beam. In addition, the surfaces 428 are also left exposed for impingement by the bias beams.

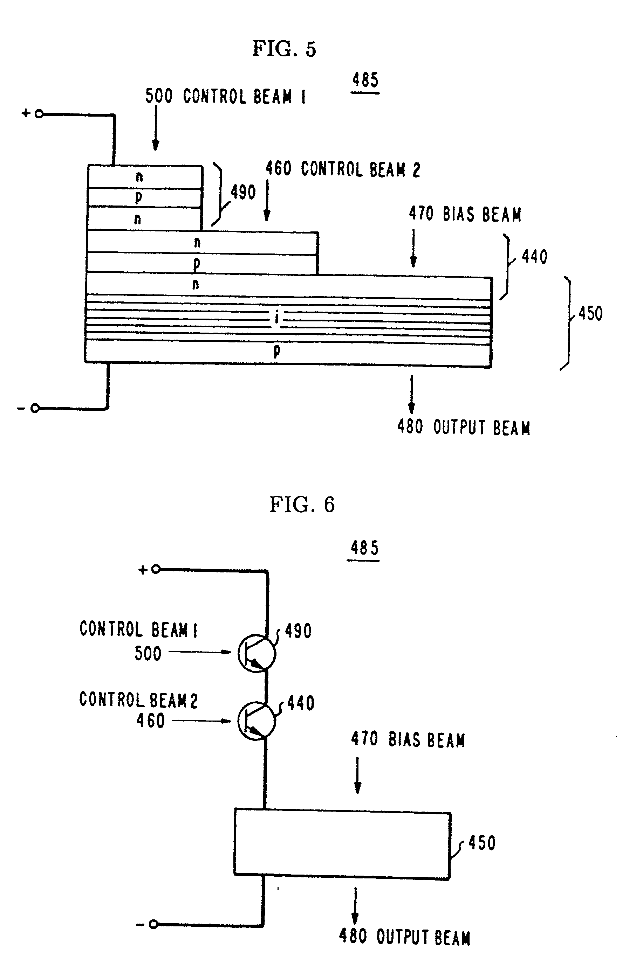

The device according to the invention is further advantageous because it is readily adaptable for use in optical logic devices. For example, the structure 485 depicted in FIG. 5 , which includes a phototransistor 490 in series with the embodiment 420, constitutes an optical NAND gate. (The corresponding electrical circuit is depicted in FIG. 6.) That is, the applied voltage is dropped across the modulator 450, thus attenuating the output beam 480, only if both phototransistors 490 and 440 are turned on by the control beams 500 and 460.

Preferably, for the demanding applications discussed above, the current gain of each of the phototransistors 490 and 440 is greater than that of the parasitic transistor inherent in the new embodiment. However, for other, nondemanding applications, this requirement is not essential.

## Claims

1. An optical device comprising an optical modulator (450) and a phototransistor (440) in series,

the optical modulator (450) comprising a multiple quantum well region (432) sandwiched between first and second semiconductor layers of opposite conductivity type (430,434) and

the phototransistor (440) being formed by further semiconductor layers (426,424) on said first layer (430)

CHARACTERISED IN THAT

the said further layers cover only a part of the said first layer, leaving a part thereof exposed to allow light (470) to pass therethrough into the modulator (450) without passing through the phototransistor (440), and

the said first layer (430) constitutes the emitter of the phototransistor (440), said further layers constituting the base (426) and collector (424) thereof.

2. An optical device as claimed in claim 1, wherein said phototransistor has a current gain greater than that of a parasitic transistor (426,430,434) inherent in said device.

3. An optical device, as claimed in claim 1 or claim 2 including a second phototransistor (490) in series with and covering a part of the first said phototransistor (440).

4. An optical device as claimed in claim 3 as dependent on claim 2, wherein said second phototransistor has a current gain greater than that of said parasitic transistor.

5. An optical device as claimed in claim 2, claim 4 or claim 3 as dependent on claim 2
wherein
the bandgap of the base region of the or each said phototransistor is less than the bandgap of the base of said parasitic transistor.

6. An optical device as claimed in claim 5
wherein
the emitter, base and collector of the or each said phototransistor include, respectively, gallium aluminum arsenide, gallium arsenide, and gallium arsenide, while the emitter, base and collector of said parasitic transistor include, respectively, gallium arsenide, gallium aluminum arsenide, and gallium aluminum arsenide.

## Revendications

1. Un dispositif optique comprenant un modulateur optique (450) et un phototransistor (440) en série, dans lequel

le modulateur optique (450) comprend une région à puits quantiques multiples (432) qui est intercalée entre des première et seconde couches de semiconducteurs ayant des types de conductivité opposés (430, 434), et

le phototransistor (440) est formé par des couches de semiconducteurs supplémentaires (426, 424) sur la première couche (430),

CARACTERISE EN CE QUE

les couches supplémentaires ne recouvrent qu'une partie de la première couche, en laissant une partie de celle-ci à nu pour permettre à la lumière (470) de passer à travers pour pénétrer dans le modulateur (450), sans traverser le phototransistor (440), et

la première couche (430) constitue l'émetteur du phototransistor (440), tandis que les couches supplémentaires constituent sa base (426) et son collecteur (424).

2. Un dispositif optique selon la revendication 1, dans lequel le phototransistor a un gain en courant supérieur à celui d'un transistor parasite (426, 430, 434) qui est inhérent à ce dispositif.

3. Un dispositif optique selon la revendication 1 ou la revendication 2, comprenant un second phototransistor (490) qui est en série avec le premier phototransistor (440) et qui recouvre une partie de celui-ci.

4. Un dispositif optique selon la revendication 3, rattachée à la revendication 2, dans lequel le second phototransistor a un gain en courant qui est supérieur à celui du transistor parasite.

5. Un dispositif optique selon la revendication 2, la revendication 4 ou la revendication 3 rattachées à la revendication 2,
dans lequel
la bande interdite de la région de base du ou de chaque phototransistor est inférieure à la bande interdite de la base du transistor parasite.

6. Un dispositif optique selon la revendication 5,
dans lequel
l'émetteur, la base et le collecteur du ou de chaque phototransistor, consistent respectivement en arséniure d'aluminium-gallium, en arséniure de gallium et en arséniure de gallium, tandis que l'émetteur, la base et le collecteur du transistor parasite consistent respectivement en arséniure de gallium, en arséniure d'aluminium-gallium et en arséniure d'aluminium-gallium.

## Patentansprüche

1. Optisches Bauelement mit folgenden Merkmalen: es weist einen optischen Modulator (450) und einen Fototransistor (440) in Serie auf;

der optische Modulator (450) weist eine als Vielfach-Quantummulde ausgebildete Region (432) auf, die zwischen ersten und zweiten Halbleiterschichten entgegengesetzten Leitfähigkeitstyp (430, 434) angeordnet ist;

der Fototransistor (440) wird durch weitere Halbleiterschichten (426, 424) auf der ersten Schicht (430) gebildet,

dadurch gekennzeichnet, daß

die weiteren Schichten nur einen Teil der ersten Schicht bedecken und einen Teil hiervon freilassen, um Licht (470) in den Modulator (450) hindurchtreten zu lassen, ohne daß dieses durch den Fototransistor (440) hindurchgeht, und

daß die erste Schicht (430) einen Emitter des Fototransistors (440) bildet, wobei die weiteren Schichten die Basis (426) und den Kollektor (424) des Fototransistors bilden.

2. Optisches Bauelement nach Anspruch 1, dadurch gekennzeichnet, daß der Fototransistor einen Stromverstärkungsfaktor größer als den eines parasitären Transistors (426, 430, 434) aufweist, der in dem Bauteil mit eingeschlossen ist.

3. Optisches Bauelement nach Anspruch 1 oder 2, dadurch gekennzeichnet, daß ein zweiter Fototransistor (490) in Serie zu dem ersten Fototransistor (440) vorgesehen ist und einen Teil dieses ersten Fototransistors bedeckt.

4. Optische Vorrichtung nach Anspruch 3, rückbezogen auf Anspruch 2, dadurch gekennzeichnet, daß der zweite Fototransistor einen Stromverstärkungsfaktor größer als den des parasitären Transistors aufweist.

5. Optische Vorrichtung nach Anspruch 2, 4 oder 3,
abhängig vom Anspruch 2,

dadurch gekennzeichnet,

daß die Bandlücke der Basisregion des oder jedes Fototransistors kleiner ist als die Bandlücke der Basis des parasitären Transistors.

6. Optische Vorrichtung nach Anspruch 5, dadurch gekennzeichnet,

daß der Emitter, die Basis und der Kollektor des oder jeden Fototransistors jeweils Galliumaluminiumarsenid, Galliumarsenid bzw. Galliumarsenid aufweisen, während der Emitter, die Basis und der Kollektor des parasitären Transistors jeweils Galliumarsenid, Galliumaluminiumarsenid bzw. Galliumaluminiumarsenid aufweisen.

## FIG. 1

420

460 CONTROL BEAM

470 BIAS BEAM

422

424

426

428

430

432

434

440

450

(GaAs) n

(GaAs) p

(GaAlAs) n

i

(GaAlAs) p

480 OUTPUT BEAM

## FIG. 2

420

CONTROL BEAM
460

440

470 BIAS BEAM

450

480 OUTPUT BEAM

## FIG. 3

## FIG. 4

## FIG. 5

<u>485</u>

500 CONTROL BEAM 1

460 CONTROL BEAM 2

470 BIAS BEAM

490

| n |
| p |
| n |

| n |
| p |
| n |

440

i

450

p

480 OUTPUT BEAM

## FIG. 6

<u>485</u>

+

CONTROL BEAM 1
500

490

CONTROL BEAM 2
460

440

470 BIAS BEAM

450

−

480 OUTPUT BEAM